(19) Europäisches Patentamt

European Patent Office

Office européen des brevets

(11) **EP 0 726 651 B1**

(12) **FASCICULE DE BREVET EUROPEEN**

(45) Date de publication et mention
de la délivrance du brevet:
**09.05.2001 Bulletin 2001/19**

(51) Int Cl.⁷: **H03H 11/30**, G01R 1/20,
G05B 11/18

(21) Numéro de dépôt: **96400255.4**

(22) Date de dépôt: **07.02.1996**

(54) **Circuit intégré avec conductance réglable à partir d'un signal numérique de consigne**

Integrierte Schaltung mit einer durch ein digitales Referenzsignal veränderlichen Konduktanz

Integrated circuit comprising a variable conductance controlled with a digital reference signal

(84) Etats contractants désignés:
**DE FR GB IT**

(30) Priorité: **08.02.1995 FR 9501458**

(43) Date de publication de la demande:
**14.08.1996 Bulletin 1996/33**

(73) Titulaire: **BULL S.A.**
**78430 Louveciennes (FR)**

(72) Inventeurs:
• **Boudry, Jean-Marie**
**F-78180 Montigny le Bretonneux (FR)**
• **Chamoun, Sleiman**
**Phoenix, 85044 Arizona (US)**

(56) Documents cités:
**EP-A- 0 408 841**     **EP-A- 0 511 536**
**US-A- 4 707 620**

## Description

L'invention se situe dans le domaine des circuits intégrés qui comportent une ou plusieurs conductances réglées sur une valeur de consigne. De tels circuits sont intéressants pour de nombreuses applications telles que par exemple les coupleurs d'entrée-sortie pour bus de données à haut débit. De tels bus sont constitués de lignes à haute fréquence qui nécessitent des impédances d'adaptation dont les conductances sont ajustées à des valeurs très précises. L'intégration de conductances dans le circuit intégré utilisateur permet un gain de place appréciable et réduit les problèmes de connexion du circuit avec un composant calibré extérieur au circuit intégré.

Pour éviter la sensibilité de l'ajustement de la conductance aux perturbations électriques et aux dérives de fonctionnement, il est préférable de commander cet ajustement par un signal numérique. Un signal numérique de consigne est élaboré de façon à approcher la valeur exacte souhaitée à l'aide de valeurs discrètes. La valeur exacte souhaitée est alors comprise dans un intervalle délimité par deux valeurs discrètes successives du signal numérique de consigne. La longueur de cet intervalle induit une erreur de la valeur de consigne sur la valeur exacte souhaitée. Le signal numérique est constamment comparé à la valeur exacte souhaitée, il a alors tendance à osciller entre les deux valeurs discrètes qui encadrent la valeur exacte. Or des oscillations sur la valeur ajustée de la conductance intégrée ne sont pas acceptables car elles modifient en permanence le courant qui la traverse et perturbent ainsi son utilisation à haute fréquence.

Une solution connue consiste à réduire la sensibilité de la comparaison du signal numérique à la valeur exacte souhaitée, à l'aide d'une bande morte dans laquelle l'erreur de comparaison n'est pas prise en compte pour modifier le signal numérique. Cette bande morte introduit une erreur absolue constante sur l'approximation de la valeur exacte souhaitée par le signal numérique. Une longueur trop faible de la bande morte par rapport à la longueur des intervalles de discrétisation de la valeur numérique rend la bande morte inefficace pour filtrer les oscillations. Une longueur de la bande morte supérieure à un intervalle de discrétisation amène une erreur supérieure à celle de ce seul intervalle. Or, pour ajuster la conductance avec une précision relative constante, il est judicieux de définir l'intervalle de discrétisation comme une proportion constante de la valeur de sa borne inférieure. Il en résulte de petits intervalles pour les faibles valeurs souhaitées et de grands intervalles pour les fortes valeurs souhaitées. Une longueur de bande morte du même ordre de grandeur que le plus petit intervalle est inefficace pour les fortes valeurs à ajuster et une longueur de bande morte du même ordre de grandeur que le plus grand intervalle introduit une erreur sur les faibles valeurs à ajuster, supérieure à l'erreur relative obtenue par les petits intervalles. Une bande morte, réduisant la sensibilité de la comparaison du signal numérique à la valeur exacte souhaitée, laisse donc subsister des difficultés pour ajuster un signal numérique avec une précision relative constante.

L'objet de l'invention est un circuit intégré comportant au moins une conductance réglable par un signal numérique de consigne discrétisant une valeur exacte avec une précision relative $\Delta p$ donnée, telle que la valeur réglée de cette conductance soit égale à la valeur exacte avec la même précision relative $\Delta p$, sans osciller entre deux valeurs encadrant ladite valeur exacte.

Pour cela, une conductance du circuit intégré conforme à l'invention est constituée de conductances élémentaires définissant chacune un échelon de valeur, tel que chaque conductance élémentaire est dimensionnée de façon à ce qu'à deux échelons de valeur successifs du signal numérique de consigne correspond un seul échelon de valeur de la conductance et tel que, s'il résulte du premier des deux échelons de valeur du signal numérique de consigne une valeur inférieure, respectivement supérieure, à la valeur exacte, la conductance élémentaire correspondante est activée, respectivement désactivée.

Il est possible d'élaborer un signal de commande numérique vérifiant les propriétés précédemment énoncées et qui soit transmis au circuit intégré conforme à l'invention. L'élaboration du signal de commande, à partir du signal de consigne, dans le circuit intégré, procure à celui-ci une plus grande autonomie.

Pour cela, le circuit intégré comporte une unité logique échantillonnant le signal de consigne avec une fréquence donnée par un signal d'horloge, élaborant un signal numérique de commande dont q bits à 1 activent q conductances élémentaires de la conductance réglable, le qième bit du signal de commande étant mis à 1, respectivement à 0, par deux échantillonnages successifs à 1, respectivement à 0, du (2q-2)ième bit du signal de consigne.

Un avantage suplémentaire est obtenu si le signal de consigne prend en compte le comportement physique du circuit intégré qui l'utilise par un capteur disposé dans le circuit.

Pour cela, le circuit intégré comporte une deuxième conductance, constituée de conductances élémentaires définissant chacune un échelon de valeur, tel que chaque conductance élémentaire est dimensionnée de façon à ce qu'à un échelon de valeur du signal numérique de consigne correspond un échelon de valeur de la conductance et en ce que, chaque bit à 1, respectivement chaque bit à 0, du signal de consigne active, respectivement désactive, une conductance élémentaire de la conductance.

Il est possible d'élaborer un signal de consigne numérique vérifiant les propriétés précédemment énoncées et qui soit transmis au circuit intégré conforme à l'invention. L'élaboration du signal de consigne, à partir de la valeur exacte souhaitée, dans le circuit intégré, procure un avantage supplémentaire du circuit par son auto adaptation intrinsèque à son environnement.

Pour cela, le circuit intégré comporte un comparateur élaborant un signal binaire dont un premier état, respectivement un deuxième état, correspond à une valeur de la deuxième conductance inférieure, respectivement supérieure, à la valeur exacte d'une conductance étalon, extérieure au circuit intégré.

La réalisation ainsi que d'autres aspects et avantages de l'invention apparaîtront dans la suite de la description en référence aux figures.

- La figure 1 montre un circuit de commande adapté à l'invention.

- La figure 2 montre une conductance intégrée réglable.

- La figure 3 montre une conductance intégrée réglable selon l'invention.

- La figure 4 montre un circuit logique pour élaborer le signal de référence.

- La figure 5 montre un circuit logique pour élaborer le signal de commande.

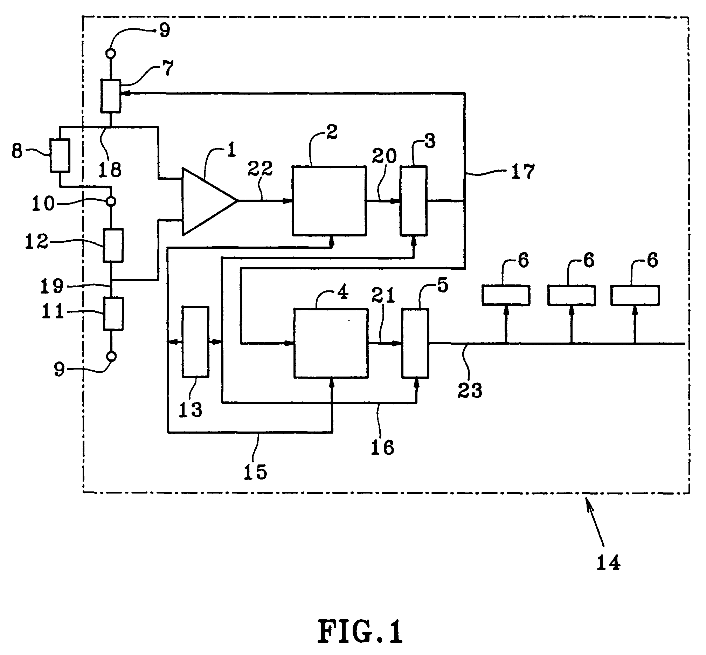

La figure 1 représente le schéma bloc d'un circuit électrique intégré dans un composant 14, connecté à une conductance étalon 8, extérieure au composant 14. La conductance 8 est connectée en série avec une conductance intégrée variable 7, entre un noeud 9 de potentiel Vh et un noeud 10 de potentiel Vss. Deux conductances intégrées 11 et 12 sont connectées en série entre les noeuds 9 et 10. Les valeurs des conductances 11 et 12 sont identiques. Le point commun 18 des conductances 7 et 8 est relié à une première entrée d'un comparateur 1. Le point commun 19 des conductances 11 et 12 est relié à une deuxième entrée du comparateur 1. Le comparateur 1 est par exemple réalisé au moyen d'un amplificateur différentiel à grand gain qui constitue un bistable. Le comparateur 1 génère un signal binaire 22 dont un premier état correspond à l'entrée en saturation basse de l'amplificateur différentiel et dont un second état correspond à l'entrée en saturation haute de l'amplificateur différentiel. Le signal 22 est envoyé à une unité logique 2 qui génère un signal numérique 20. Le signal 20 est constitué de 2n signaux binaires, ou bits, stockés dans un registre 3. La valeur numérique du signal 20 est directement égale au nombre de bits à 1. Un générateur d'horloge 13 génère un premier signal d'horloge 15 et un second signal d'horloge 16 de même fréquence et déphasé sur le premier signal d'horloge. Initialement, seul le premier bit du signal 20 est à 1, ceci correspond à une valeur talon en dessous de laquelle il ne peut pas descendre, les 2n-1 autres bits du signal 20 sont à 0. A chaque impulsion du signal 15, l'unité logique 2 incrémente d'une unité le signal 20 sur le premier état du signal 22, en faisant passer de 0 à 1 un bit supplémentaire de ce signal, tant qu'il existe un bit à 0. A chaque impulsion du signal 15, l'unité logique 2 décrémente d'une unité la valeur du signal 20 sur le deuxième état du signal 22, en faisant passer de 1 à 0 un bit de ce signal, tant qu'il existe un bit à 1 autre que le premier bit. A chaque impulsion du signal 16, le registre 3 mémorise le signal 20 sous forme d'un signal 17 de 2n bits égaux aux 2n bits du signal 20.

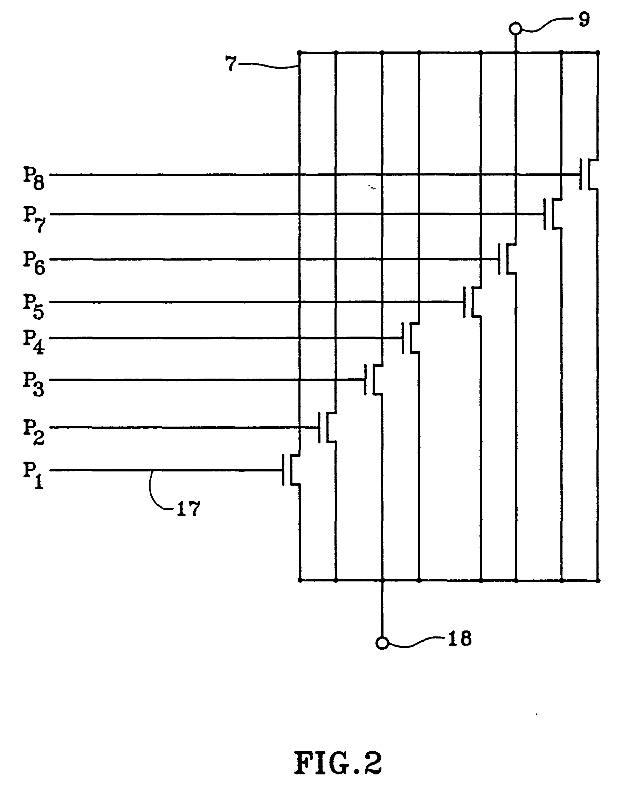

La figure 2 donne un exemple de réalisation de la conductance intégrée variable 7. La conductance 7 est constituée de 2n transistors MOS. Dans cet exemple, n est égal à quatre mais les explications restent valables pour un nombre n quelconque. La conductance de chaque transistor MOS est proportionnelle à la largeur W et inversement proportionnelle à la longueur l de son chemin drain-source. Les drains de tous les transistors sont connectés au noeud 9 et les sources de tous les transistors sont connectés au noeud 18. La grille de chaque transistor est commandée par un bit différent du signal 17. Ainsi, les p premiers bits à 1 du signal 17 rendent passants les p premiers transistors du réseau constituant la conductance 7 alors que les 2n-p autres bits à 0 du signal 17 rendent les 2n-p autres transistors bloquants. De cette manière, les p transistors passants définissent la valeur de la conductance 7. Le passage de 0 à 1 d'un bit du signal 17 augmente donc la valeur de la conductance 7 d'une valeur définie par la largeur W et la longueur l du transistor mis en conduction par ce bit. Le premier transistor du réseau est dimensionné de façon à avoir une conductance du même ordre de grandeur que la conductance 8 mais de valeur nettement inférieure. Il constitue un talon de conductance en dessous duquel la conductance 7 ne peut pas descendre. Les autres transistors du réseau sont dimensionnés de façon à ce que la conductance de chacun constitue un incrément de conductance, et que la conductance cumulée de tous les transistors du réseau soit nettement supérieure à la valeur de la conductance 8. Les incréments sont de valeur croissante de façon à ce que le rapport de chacun à la somme des conductances précédentes soit sensiblement constant. Ceci permet d'obtenir une précision relative $\Delta p$ constante.

Sur le schéma de la figure 1, les conductances 11 et 12 étant égales, le potentiel de leur point commun 19 est égal au potentiel du point commun 18 des conductances 7 et 8 lorsque leurs valeurs sont égales. Lorsque la valeur de la conductance 7 est inférieure à celle de la conductance 8, le potentiel du point commun 18 amène l'amplificateur du comparateur 1 en saturation basse générant le premier état du signal 22. A chaque impulsion du signal 15, puis à chaque impulsion du signal 16, un bit supplémentaire du signal 17 passe de 0 à 1. Comme nous l'avons vu précédemment, ceci a pour effet d'augmenter la valeur de la conductance 7. Lorsque la valeur de la conductance 7 est supérieure à celle de la conductance 8, le potentiel du point commun 18 amène l'amplificateur du comparateur 1 en saturation haute générant le deuxième état du signal 22. A chaque impulsion du signal 15, puis à chaque impulsion du signal 16, un bit supplémentaire du signal 17 passe de 1 à 0. Comme nous l'avons vu précédemment, ceci a pour effet de diminuer la valeur de la conductance 7. La valeur de la conductance 7 finit par osciller entre une première valeur discrète immédiatement inférieure à celle de la conductance 8 et une seconde valeur discrète immédiatement supérieure à celle de la conductance 8. Dans le réseau de la figure 2, la première valeur correspond à p transistors mis en conduction et la seconde valeur correspond à p+1 transistors mis en conduction. A chaque instant, la différence de valeur entre celle de la conductance 7 et celle de la conductance 8 est inférieure à la conductance du p+1ième transistor mis alternativement en et hors conduction par le signal 17. Le signal 17 constitue le signal numérique de consigne pour approcher la valeur exacte donnée par la conductance 8.

Simultanément à sa transmission vers la conductance 7, le signal 17 est transmis à une unité logique 4 qui génère un signal numérique 21. Le signal 21 est constitué de n+1 signaux binaires, ou bits, stockés dans un registre 5. La valeur numérique du signal 21 est directement égale au nombre de bits à 1. A chaque impulsion du signal 16, le signal 21 est mémorisé dans un registre 5 sous forme d'un mot de n+1 bits égaux un à un aux n+1 bits du signal 21. Ce mot est transmis sous forme d'un signal 23 à n+1 bits, en parallèle, vers une ou plusieurs conductances intégrées variables 6.

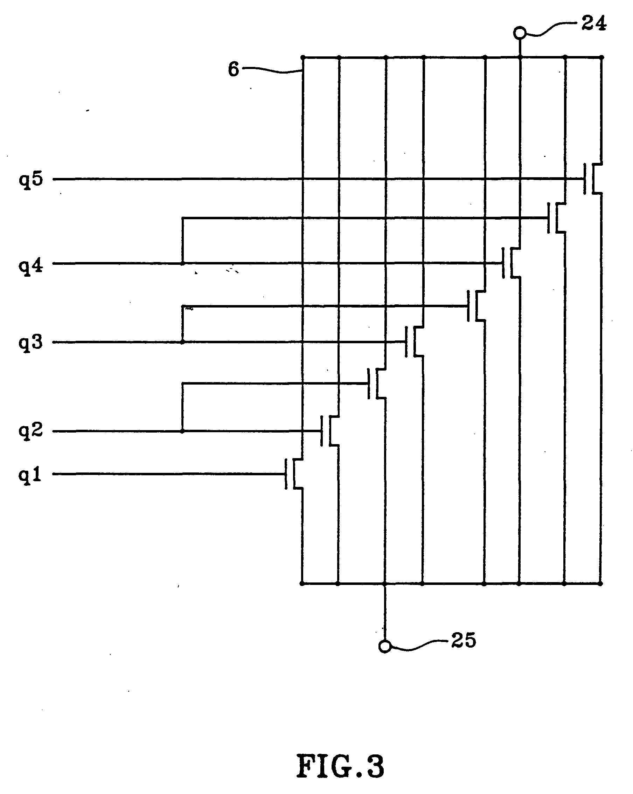

La figure 3 donne un exemple de réalisation de la conductance intégrée variable 6. La conductance 6 est constituée d'un réseau de 2n transistors, identique au réseau de 2n transistors de la conductance 7. Les drains de tous les transistors sont connectés à un noeud 24 et les sources de tous les transistors sont connectés à un noeud 25. Il est ainsi possible d'utiliser la conductance 6 dans le composant 14 en connectant les noeud 24 et 25 à d'autres éléments de ce composant. Le premier et le dernier bit du signal 23 commandent respectivement le premier et le dernier transistor du réseau. Chacun des autres bits du signal 23 commande simultanément les grilles de deux transistors du réseau constituant la conductance 6. Le transistor commandé par le premier bit du signal 23 correspond au premier transistor du réseau de la conductance 7. Pour les valeurs de q allant de 2 à n, chaque paire de transistors commandée par le qième bit du signal 23 correspond aux transistors du réseau de la conductance 7 qui sont commandés par le (2q-2)ième et le (2q-1)ième bit du signal 17. Ainsi, les q premiers bits à 1 du signal 23 rendent passants les (2q-1) premiers transistors du réseau constituant la conductance 6 alors que les (n+1-q) autres bits à 0 du signal 23 rendent les (2n-2q+1) autres transistors bloquants. De cette manière, les (2q-1) transistors passants déterminent la valeur de la conductance 6. Le transistor commandé par le (n+1)ième bit du signal 23 correspond au 2nième transistor du réseau de la conductance 7. Le passage de 0 à 1 d'un bit du signal 23 augmente donc la valeur de la conductance 6 d'une valeur définie par la largeur W et la longueur l du ou des deux transistors mis en conduction par ce bit. De la sorte, chaque conductance élémentaire détermine un échelon correspondant à deux échelons de valeur successifs du signal numérique de consigne.

Le signal 21 est élaboré de la façon suivante par l'unité logique 4. Lorsque le pième bit du signal 17 passe à 1 avec p=2q-1, le qième bit du signal 21 passe à 1, et ne repasse à 0 que lorsque le pième bit du signal 17 passe à 0 avec p=2q-2. Le passage à 1 du (2q-2) ième bit ou le passage à 0 du (2q-1)ième bit du signal 17 laissent inchangé le qième bit du signal 21. Cependant, si le (2q-2)ième bit du signal 17, avec q=n+1 persiste à 1, cela signifie que le signal 17 est entré en saturation à la valeur n. Le (n+1)ième bit du signal 17 est alors mis à 1. De la sorte, l'incrémentation, respectivement la double décrémentation, de la valeur du signal numérique de consigne comprise entre deux valeurs successives de la conductance intégrée commute, respectivement interrompt, une conductance élémentaire de la conductance intégrée 6.

Ainsi, lorsque le signal 17 oscille entre les valeurs (2q-1) et (2q-2), ou entre les valeurs (2q-1) et 2q, le signal 23, image du signal 21, reste stable à la valeur (2q-1). Lorsque les q premiers bits du signal 23 rendent passant les (2q-1) premiers transistors de la conductance 6, le signal 17 rend passant les p premiers transistors de la conductance 7 avec p=2q-1 ou p=2q ou p=2q-2. La conductance 6 et la conductance 7 étant intégrées dans le même composant 14, des structures identiques de leurs transistors donnent les mêmes valeurs de conductances, indépendamment des dérives de fonctionnement et des dispersions de fabrications dont les caractéristiques sont communes à tous les éléments d'un même composant. Ainsi la valeur de la conductance 6 est égale à la valeur de la conductance 7 à la valeur de conductance près égale au maximum des conductances du 2qième et du (2q-1)ième dernier transistor passant de chacune de ces conductances.

Lorsqu'en régime établi, la valeur du signal 17 oscille entre 2q-1 et 2q, nous avons vu précédemment que ceci correspond à deux valeurs de la conductance 7 correspondant à 2q-1 et 2q transistors passants de cette conductance et que la valeur de la conductance étalon 8 est comprise entre ces deux valeurs de la conductance 7. De même, lorsqu'en régime établi, la valeur du signal 17 oscille entre 2q-1 et 2q-2, nous avons vu précédemment que ceci correspond à deux valeurs de la conductance 7 correspondant à 2q-1 et 2q-2 transistors passants de cette conductance et que la valeur de la conductance étalon 8 est comprise entre ces deux valeurs de la conductance 7. Lorsque la conductance 7 oscille entre deux valeurs discrètes qui encadrent, avec une précision relative $\Delta p$, la valeur de la conductance 8, la conductance 6 reste donc de façon stable sur une de ces deux valeurs, correspondant à 2q-1 transistors passants et avec la même précision relative sur la valeur de la conductance 8. L'erreur n'est pas plus importante que pour la conductance 7 mais la conductance 6 présente l'avantage de ne pas osciller entre deux valeurs encadrant celle de la conductance 8.

Ainsi, le signal discret 17 approche la valeur réelle de conductance souhaitée en oscillant entre deux valeurs successives qui encadrent cette valeur réelle. L'unité 4 permet d'ajuster la valeur de la conductance 6 à une valeur stable sans changer l'intervalle d'erreur approchant la valeur réelle souhaitée dans le signal 17.

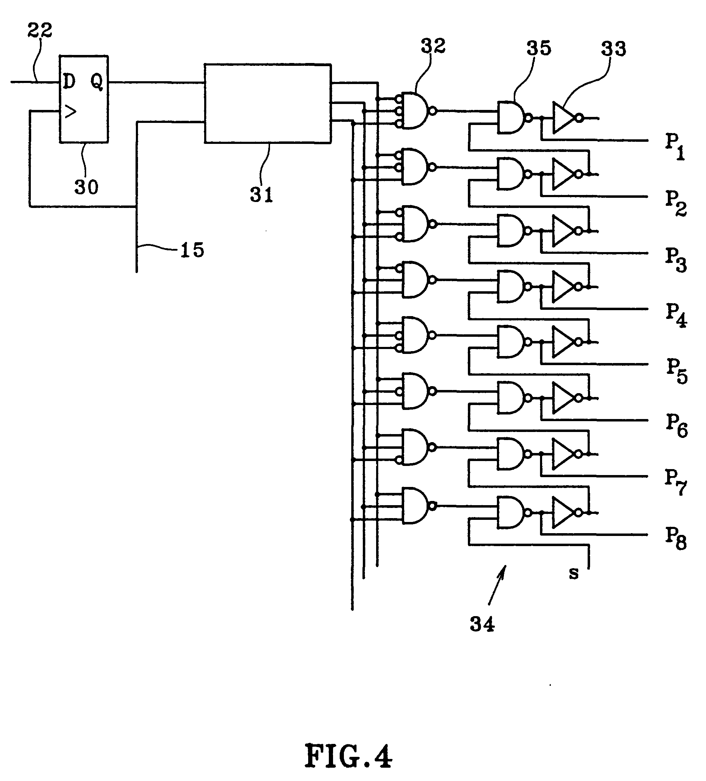

La figure 4 présente un exemple de réalisation de l'unité logique 2. L'unité logique 2 comprend une bascule 30 de type D, un compteur 31 de type DCB (décimal codé binaire) et un circuit combinatoire 34 constitué d'inverseurs 33 et de portes NAND 32 et 35. La sortie Q de la bascule 30 change d'état à chaque impulsion du signal 15, suivant le signe du signal 22. Le compteur 31 change d'état à chaque impulsion du signal 15, d'un incrément positif si la sortie Q est à 1 et d'un incrément négatif si la sortie Q est à 0. La bascule 30 change d'état par exemple sur le front montant du signal 15 et le compteur 31 change d'état sur le front descendant du signal 15. Si la largeur de l'impulsion 15 est suffisante, on est alors certain que la bascule 30 aura un état stable 0 ou 1 au moment du fonctionnement du compteur 31, même dans le cas métastable où le signal 22 serait juste dans l'état intermédiaire entre le niveau 0 et le niveau 1. Ainsi, deux valeurs successives du compteur 31 sont nécessairement différentes d'une unité. Le nombre de bits de sortie du compteur 31 est égal à l'exposant de la puissance de 2 du nombre de bit du signal 20 en sortie de l'unité 2. Le compteur 31 possède une butée pour tous ses bits à 0 qui lui interdit de décompter en dessous de la valeur nulle et une butée pour tous ses bits à 1 qui lui interdit de compter au dessus de la valeur maximale 2n. Dans l'exemple où le nombre de bits du signal 20 est 2n=8, le compteur 31 est un compteur à trois bits. Le signal 20 est constitué de 2n bits, p1 à p8. Le ième bit du signal 20 est mis à 1 par la ième porte 32 lorsque la valeur du compteur est égale à i, il est maintenu à 1 par la ième porte 35 tant que le (i+1)ième bit est à 1. Le 2nième bit n'est maintenu par aucun bit suivant, pour cela, il est par exemple possible d'alimenter la deuxième entrée de la 2nième porte 35 par un signal s constamment à 1.

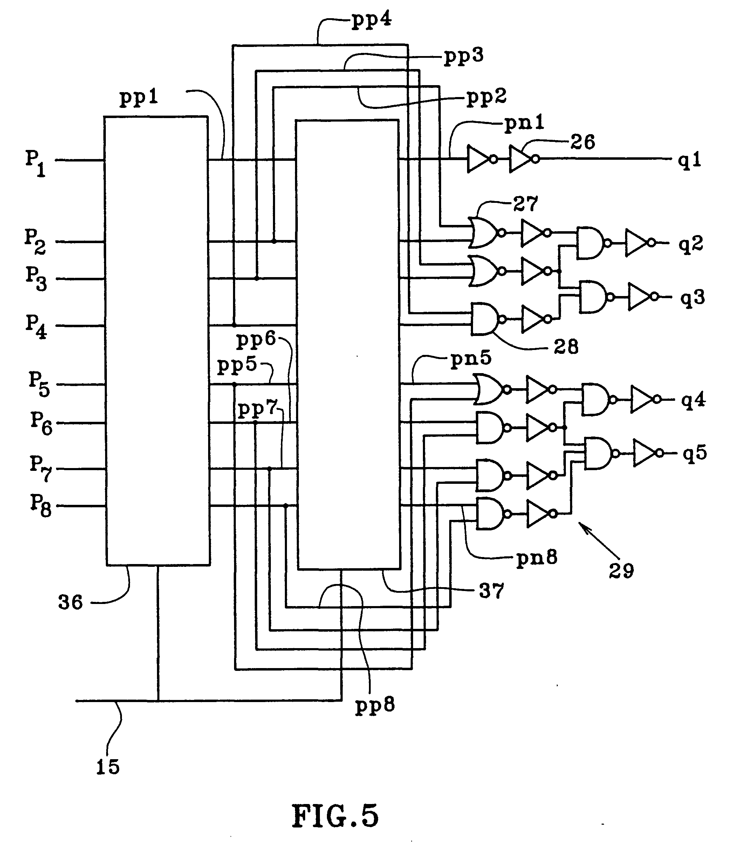

La figure 5 présente un exemple de réalisation de l'unité logique 4. L'unité logique 4 comprend un registre à bascules 36, rafraîchi par le signal d'horloge 15. Le registre 36 reçoit en entrée le signal 17 par 2n brins p1 à p8. Du registre 36 sortent 2n brins pp1 à pp8 véhiculant chacun un bit égal à celui de chacun des 2n brins p1 à p8 sur le front montant du signal 15. Chacun des brins pp1 à pp8 est raccordé simultanément à un registre à bascules 37 et à un circuit combinatoire 29 composé d'inverseurs 26, de portes NOR 27 et de portes NAND 28. Le registre à bascule 37 est rafraîchi par le signal d'horloge 15. Du registre 37 sortent 2n brins pn1 à pn8 véhiculant chacun un bit égal à celui de chacun des 2n brins pp1 à pp8 sur le front montant du signal 15. Comme, sur le même front montant du signal 15, les bits des brins pp1 à pp8 sont rafraîchis, les bits des brins pn1 à pn8 sont égaux aux bits des brins pp1 à pp8 un cycle d'horloge précédent. Les 2n brins en sortie du registre 37 sont raccordés au circuit combinatoire 29. Le circuit combinatoire 29 élabore n+1 signaux binaires, qui dans l'exemple de la figure 2 sont référencés q1 à q5. Les signaux q1 à q5 vérifient les équations logiques qui suivent, où + symbolise la disjonction logique et • symbolise la conjonction logique.

$$q1=pn1.$$

Ceci assure un talon de valeur pour la conductance 6, identique à celui de la conductance 7.

$$q2=(pp2+pn2)•(pp3+pn3).$$

Les bits du signal étant successivement mis à 1 suivant leur rang croissant ou à 0 suivant leur rang décroissant, q2 est mis à 1 dès que pp3 est mis à 1, q2 est remis à 0 dès que pp2 passe à 0 car alors pp3 et pn3 sont à 0.

$$q3=(pp3+pn3)•(pp4•pn4).$$

Le bit q3 est mis à 1 si le bit p4 est deux fois de suite à 1, c'est à dire, le signal 17 évoluant en permanence, si le bit p5 est mis à 1. Le bit q3 est remis à 0 dès que pp4, c'est à dire p4 passe à 0.

$$q4=(pp5+pn5)•(pp6•pn6).$$

$$q5=(pp6•pn6)•(pp7•pn7)•(pp8•pn8).$$

Le bit q4 est mis à 1 si le bit p6 est deux fois de suite à 1, c'est à dire, le signal 17 évoluant en permanence, si le bit p7 est mis à 1. Le bit q4 est remis à 0 dès que pp6, c'est à dire p6 passe à 0. Le bit q5 est mis à 1 si le bit p8 est deux fois de suite à 1, c'est à dire, le signal 17 évoluant en permanence, si un bit, virtuel ou réel, p9 est mis à 1. Le bit q5 est remis à 0 dès que pp8, c'est à dire p8 passe à 0.

Nous remarquons ainsi que les bits q1 à q5 vérifient les conditions posées précédemment sur un signal 21 à n+1 bits avec n=4. Pour les puissances de 2 supérieures à 4, il suffit d'appliquer chacune des deux dernières équations donnant q4 et q5 à chacune des paires de bits suivantes. Par exemple, pour n=8:

$$q6=(pp9+pn9)\bullet(pp10\bullet pn10).$$

$$q7=(pp10\bullet pn10)\bullet(pp11\bullet pn11)\bullet(pp12\bullet pn12).$$

$$q8= (pp13+pn13)\bullet(pp14\bullet pn14).$$

$$q9=(pp14\bullet pn14)\bullet(pp15\bullet pn15)\bullet(pp16\bullet pn16).$$

D'autres circuits combinatoires 29, se déduisant aisément de la fonction à réaliser restent dans le cadre de la présente invention.

**Revendications**

1. Circuit intégré comportant au moins une première conductance (6) réglable à partir d'un signal numérique de consigne (17) codant des échelons de valeur pour discrétiser une valeur exacte (8) avec une précision relative $\Delta p$ fixée, la première conductance (6) étant constituée de premières conductances élémentaires définissant chacune un échelon de valeur, caractérisé en ce que chaque première conductance élémentaire est dimensionnée de façon à ce qu'un échelon de valeur de la première conductance (6) correspond à deux échelons de valeur successifs du signal numérique de consigne (17) et en ce que, si le premier des deux échelons de valeur du signal numérique de consigne (17) discrétise (7) une valeur inférieure, respectivement supérieure, à la valeur exacte (8), la première conductance élémentaire correspondante est activée, respectivement désactivée.

2. Circuit intégré comportant au moins une première conductance (6) réglable à partir d'un signal numérique de consigne (17) suivant la revendication 1, caractérisé en ce qu'il comporte une unité logique (4) échantillonnant le signal de consigne (17) avec une fréquence donnée par un signal d'horloge (15), élaborant un signal numérique de commande (21) dont q bits à 1 activent q premières conductances élémentaires de la première conductance (6), le qième bit du signal de commande (21) étant mis à 1, respectivement à 0, par deux échantillonnages successifs à 1, respectivement à 0, du (2q-2)ième bit du signal de consigne (17).

3. Circuit intégré comportant au moins une première conductance (6) réglable à partir d'un signal numérique de consigne (17) suivant la revendication 1, caractérisé en ce qu'il comporte une unité logique (4), élaborant un signal numérique de commande (21) dont q bits à 1 activent q premières conductances élémentaires de la première conductance (6), le qième bit du signal de commande (21) étant mis à 1, respectivement à 0, par la mise à 1 du (2q-1) ième bit, respectivement la mise à 0 du (2q-2)ième bit, du signal de consigne (17).

4. Circuit intégré comportant au moins une première conductance (6) réglable à partir d'un signal numérique de consigne (17) suivant la revendication 1, caractérisé en ce qu'il comporte une deuxième conductance (7), constituée de deuxièmes conductances élémentaires définissant chacune un échelon de valeur, caractérisé en ce que chaque deuxième conductance élémentaire est dimensionnée de façon à ce qu'à un échelon de valeur du signal numérique de consigne (17) correspond un échelon de valeur de la deuxième conductance (7) et en ce que, chaque bit à 1, respectivement chaque bit à 0, du signal de consigne (17) active, respectivement désactive, une deuxième conductance élémentaire de la deuxième conductance (7).

5. Circuit intégré comportant au moins une première conductance (6) réglable à partir d'un signal numérique de consigne (17) suivant la revendication 4, caractérisé en ce qu'il comporte un comparateur (1) élaborant un signal binaire (22) dont un premier état, respectivement un deuxième état, correspond à une valeur de la deuxième conductance (7) inférieure, respectivement supérieure, à la valeur exacte d'une troisième conductance (8), extérieure au circuit intégré.

6. Circuit intégré comportant au moins une première conductance (6) réglable à partir d'un signal numérique de consigne (17) suivant la revendication 5, caractérisé en ce qu'il comporte une unité logique (2) échantillonnant le signal binaire (22) avec une fréquence donnée par un signal d'horloge (15), élaborant un signal numérique (20), un pième bit du signal numérique (20) étant mis à 1, respectivement à 0, par un échantillonnage du premier état, respectivement du deuxième état, du signal binaire (22).

7. Circuit intégré comportant au moins une première conductance (6) réglable à partir d'un signal numérique de consigne (17) suivant la revendication 6, caractérisé en ce que l'unité logique (2) est constituée d'un compteur (31) et d'un circuit combinatoire (34), le compteur (31) étant incrémenté, respectivement décrémenté, par le premier état, respectivement le deuxième état, du signal binaire (22), le circuit combinatoire (34) mettant un nombre p de bits à 1 du signal numérique (20), égal à la valeur donnée par le compteur (31).

**Claims**

1. Integrated circuit comprising at least a first conductance (6) that is adjustable on the basis of a reference digital signal (17) encoding steps in value so as to quantize an exact value (8) with a fixed relative accuracy $\Delta$p, the first conductance (6) being constituted by first elementary conductances each defining a step in value, characterised in that each first elementary conductance is dimensioned such that a step in value of the first conductance (6) corresponds to two successive steps in value of the reference digital signal (17) and in that, if the first of the two steps in value of the reference digital signal (17) quantizes (7) a value that is lower or higher, respectively, than the exact value (8), the corresponding first elementary conductance is activated or deactivated, respectively.

2. Integrated circuit comprising at least a first conductance (6) that is adjustable on the basis of a reference digital signal (17) according to Claim 1, characterised in that it comprises a logic unit (4) sampling the reference signal (17) with a frequency given by a clock signal (15), producing a digital control signal (21), of which q bits set to 1 activate q first elementary conductances of the first conductance (6), the qth bit of the control signal (21) being set to 1 or 0 respectively, by two successive samplings set to 1 or 0, respectively, of the (2q-2)th bit of the reference signal (17).

3. Integrated circuit comprising at least a first conductance (6) that is adjustable on the basis of a reference digital signal (17) according to Claim 1, characterised in that it comprises a logic unit (4), producing a digital control signal (21), of which q bits set to 1 activate q first elementary conductances of the first conductance (6), the qth bit of the control signal (21) being set to 1 or 0 respectively, by setting to 1 the (2q-1)th bit or setting to 0 the (2q-2)th bit, respectively, of the reference signal (17).

4. Integrated circuit comprising at least a first conductance (6) that is adjustable on the basis of a reference digital signal (17) according to Claim 1, characterised in that it comprises a second conductance (7), constituted by second elementary conductances each defining a step in value, characterised in that each second elementary conductance is dimensioned such that one step in value of the reference digital signal (17) corresponds to a step in value of the second conductance (7) and in that each bit set to 1 or each bit set to 0, respectively, of the reference signal (17) activates or deactivates, respectively, a second elementary conductance of the second conductance (7).

5. Integrated circuit comprising at least a first conductance (6) that is adjustable on the basis of a reference digital signal (17) according to Claim 4, characterised in that it comprises a comparator (1) producing a binary signal (22), of which a first state or a second state, respectively, corresponds to a value of the second conductance (7) that is lower or higher, respectively, than the exact value of a third conductance (8), external to the integrated circuit.

6. Integrated circuit comprising at least a first conductance (6) that is adjustable on the basis of a reference digital signal (17) according to Claim 5, characterised in that it comprises a logic unit (2) sampling the binary signal (22) with a frequency given by a clock signal (15), producing a digital signal (20), a pth bit of the digital signal (20) being set to 1 or 0, respectively, by sampling the first state or the second state, respectively, of the binary signal (22).

7. Integrated circuit comprising at least a first conductance (6) that is adjustable on the basis of a reference digital signal (17) according to Claim 6, characterised in that the logic unit (2) is constituted by a counter (31) and a combinatory circuit (34), the counter (31) being incremented or decremented, respectively, by the first state or the second state, respectively, of the binary signal (22), the combinatory circuit (34) setting a number p of bits to 1 of the digital signal (20), equal to the value given by the counter (31).

**Patentansprüche**

1. Integrierte Schaltung, die wenigstens eine erste Konduktanz (6) besitzt, die anhand eines digitalen Stellsignals (17) einstellbar ist, das die Stufen eines Wertes codiert, um einen exakten Wert (8) mit einer festen relativen Genauigkeit $\Delta$p zu diskretisieren, wobei die erste Konduktanz (6) aus ersten elementaren Konduktanzen gebildet ist, die jeweils eine Wertestufe definieren, dadurch gekennzeichnet, daß jede erste elementare Konduktanz so dimensioniert ist, daß eine Wertestufe der ersten Konduktanz (6) zwei aufeinanderfolgenden Wertestufen des digitalen Stellsignals (17) entspricht, und daß dann, wenn die erste der beiden Wertestufen des digitalen Stellsignals (17) einen in bezug auf den exakten Wert (8) kleineren bzw. größeren Wert diskretisiert, die entsprechende erste elementare Konduktanz aktiviert bzw. deaktiviert wird.

2. Integrierte Schaltung mit wenigstens einer ersten anhand eines digitalen Stellsignals (17) einstellbaren Konduktanz (6) nach Anspruch 1, dadurch gekennzeichnet, daß sie eine Logikeinheit (4) enthält, die das Stellsignal (17) mit einer durch ein Taktsignal (15) gegebenen Frequenz abtastet und ein digitales Steuersignal (21) erzeugt, wovon q Bits mit Wert 1 q erste elementare Konduktanzen der ersten Konduktanz (6) aktivieren, wobei das q-te Bit des Steuersignals (21) durch zwei aufeinanderfolgende Abtastwerte mit Wert 1 bzw. 0 des (2q - 2)-ten Bits des Stellsignals (17) auf 1 bzw. 0 gesetzt wird.

3. Integrierte Schaltung mit wenigstens einer ersten anhand eines digitalen Stellsignals (17) einstellbaren Konduktanz (6) nach Anspruch 1, dadurch gekennzeichnet, daß sie eine Logikeinheit (4) enthält, die ein digitales Steuersignal (21) erzeugt, wovon q Bits mit Wert 1 q erste elementare Konduktanzen der ersten Konduktanz (6) aktivieren, wobei das q-te Bit des Steuersignals (21) durch Setzen auf 1 des (2q - 1)-ten Bits bzw. durch Setzen auf 0 des (2q - 2)-ten Bits des Stellsignals (17) auf 1 bzw. auf 0 gesetzt wird.

4. Integrierte Schaltung mit wenigstens einer ersten anhand eines digitalen Stellsignals (17) einstellbaren Konduktanz (6) nach Anspruch 1, dadurch gekennzeichnet, daß sie eine zweite Konduktanz (7) enthält, die aus zweiten elementaren Konduktanzen gebildet ist, die jeweils eine Wertestufe definieren, dadurch gekennzeichnet, daß jede zweite elementare Konduktanz so dimensioniert ist, daß einer Wertestufe des digitalen Stellsignals (17) eine Wertestufe der zweiten Konduktanz (7) entspricht und daß jedes Bit mit Wert 1 bzw. jedes Bit mit Wert 0 des Stellsignals (17) eine zweite elementare Konduktanz der zweiten Konduktanz (7) aktiviert bzw. deaktiviert.

5. Integrierte Schaltung mit wenigstens einer ersten anhand eines digitalen Stellsignals (17) einstellbaren Konduktanz (6) nach Anspruch 4, dadurch gekennzeichnet, daß sie einen Komparator (1) enthält, der ein binäres Signal (22) erzeugt, wovon ein erster Zustand bzw. ein zweiter Zustand einem Wert der zweiten Konduktanz (7) entspricht, der in bezug auf den exakten Wert einer dritten Konduktanz (8) außerhalb der integrierten Schaltung kleiner bzw. größer ist.

6. Integrierte Schaltung mit wenigstens einer ersten anhand eines digitalen Stellsignals (17) einstellbaren Konduktanz (6) nach Anspruch 5, dadurch gekennzeichnet, daß sie eine Logikeinheit (2) enthält, die das binäre Signal (22) mit einer durch ein Taktsignal (15) gegebenen Frequenz abtastet und ein digitales Signal (20) erzeugt, wobei ein p-tes Bit des digitalen Signals (20) durch eine Abtastung des ersten Zustands bzw. des zweiten Zustands des binären Signals (22) auf 1 bzw. auf 0 gesetzt wird.

7. Integrierte Schaltung mit wenigstens einer ersten anhand eines digitalen Stellsignals (17) einstellbaren Konduktanz (6) nach Anspruch 6, dadurch gekennzeichnet, daß eine Logikeinheit (2) aus einem Zähler (31) und einer kombinatorischen Schaltung (34) gebildet ist, wobei der Zähler (31) durch den ersten Zustand bzw. den zweiten Zustand des binären Signals (22) inkrementiert bzw. dekrementiert wird, wobei die kombinatorische Schaltung (34) eine Anzahl p von Bits mit Wert 1 des digitalen Signals (20) gleich dem durch den Zähler (31) gegebenen Wert macht.

**FIG.1**

FIG.2

FIG.3

FIG.4

FIG.5